# EUROPEAN PATENT SPECIFICATION

(11) **EP 4 207 719 B1**
(45) Date of publication and mention of the grant of the patent: **04.11.2026**
(21) Application number: 22176545.6
(22) Date of filing: 31.05.2022
(51) Int. Cl.: G03B 17/56, G03B 30/00, G06F 1/20, H04M 1/02, H04M 1/21, G06F 1/16, G03B 17/14

(54) **MOBILE TERMINAL AND MOBILE DEVICE**
MOBILES ENDGERÄT UND MOBILE VORRICHTUNG
TERMINAL MOBILE ET DISPOSITIF MOBILE

(30) Priority: 29.12.2021 CN 202111640093
(43) Date of publication of application: 05.07.2023
(60) Divisional application: 26208373.6
(73) Proprietor: Beijing Xiaomi Mobile Software Co., Ltd., Beijing 100085 (CN)
(72) Inventor: YANG, Zongbao, Beijing, 100085 (CN); LIU, Wei, Beijing, 100085 (CN); ZHENG, Yan, Beijing, 100085 (CN)
(74) Representative: dompatent

(56) References cited:
- CN-U- 214 799 611
- US-A1- 2018 167 497
- US-A1- 2018 198 897
- US-A1- 2020 169 651

## Description

### TECHNICAL FIELD

The disclosure relates to the technical field of electronics, and in particular to a mobile terminal and a mobile device.

### BACKGROUND

Mobile terminals such as mobile phones generally include a built-in camera module to achieve a shooting function. The camera module is integrated in the body of the mobile terminal, including an image sensor, a lens, a focusing module, an anti-shake motor and other main components, so as to obtain a good imaging picture quality in a limited space.

However, in the related art, the structure and size of the built-in camera module of the mobile terminal are limited by the overall size of the mobile terminal. If the overall layout of the mobile terminal is considered, the function and imaging quality of the built-in camera module cannot be improved. If the camera module is too thick, the overall thickness of the mobile terminal may be large, the aesthetics and a user experience may be reduced, and a layout area of a main board of the mobile terminal and installation spaces of other parts such as a battery capacity may also be affected.

US2020/169651A1 disclosed a camera module for imaging device includes a light sensing module, a control circuit, a mounting member, one or more external lens modules, and a magnetic sensing element. The control circuit sets photographic conditions for a certain external lens module according to a control signal, the control signal being prompted by the magnetic sensing element detecting the type of the external lens module by the arrangement of magnetic components therein, as detected by the magnetic sensing element. The magnetic components have configurations corresponding to the type of the external lens module and the magnetic components assist in aligning one external lens module to the body of the imaging device. Other relevant prior art is known from US2018/198897A1, CN214799611U, and US2018/167497A1.

### SUMMARY

The disclosure provides an improved mobile terminal and mobile device to avoid the space occupation of the mobile terminal by a lens, such that the mobile terminal has both the lightness and thinness and an expected shooting effect.

According to the invention, a mobile terminal is provided, including:
a device housing, comprising a light-permeable portion and an external connection portion whereby an external lens assembly is able to be positioned and mounted on the external connection region of the mobile terminal, wherein a first assembly space corresponding to the light-permeable portion is arranged inside the device housing, and
an image sensor assembly is arranged inside the first assembly space, and the external connection region is arranged at least to cover a photosensitive unit of the image sensor assembly.

Optionally, the device housing includes a first bracket, including a bracket body and a first accommodation space surrounded by the bracket body, and the image sensor assembly is assembled in the first accommodation space.

Optionally, the bracket body includes a heat dissipation structure, and at least a part of the image sensor assembly is in a contacting fit with the heat dissipation structure.

Optionally, the mobile terminal further includes an antenna cover integrally formed with the first bracket.

Optionally, the device housing includes a middle frame and a decorative cover plate assembled in the middle frame, and the external connection portion is arranged on the decorative cover plate.

Optionally, the image sensor assembly is assembled and fixed with the decorative cover plate.

Optionally, the decorative cover plate includes a cover plate body and an installing structure; the cover plate body is arranged at a periphery of the light-permeable portion and covers at least a part of the mobile terminal, and the installing structure surrounds and forms a second accommodation space inside the mobile terminal, the image sensor assembly is assembled in the second accommodation space.

Optionally, the mobile terminal further includes a plurality of threaded connection members, the decorative cover plate and the middle frame are fixed by the threaded connection members.

Optionally, the image sensor assembly includes an optical filter, a sensor body, and a circuit board, the optical filter is arranged above the sensor body and covers the photosensitive unit of the sensor body, and the circuit board is arranged below the sensor body.

According to the invention, the image sensor assembly further includes a protective cover and a sealing member, wherein the protective cover covers edge regions of the optical filter, the sensor body and the circuit board; the light-permeable portion includes a light-permeable cover plate, the sealing member is arranged at an edge region between the light-permeable cover plate and the protective cover, and is respectively in a sealing fit with the light-permeable cover plate and the protective cover.

Optionally, the size of the photosensitive unit of the image sensor assembly is greater than or equal to 16 mm.

Optionally, the external connection portion includes at least one of a clamping structure, a threaded connection structure and a magnetic connection structure arranged in the device housing.

Optionally, the mobile terminal further includes a decorative cover body assembled outside the device housing and covering at least one of the light-permeable portion and the external connection portion.

Optionally, the mobile terminal further includes at least one of a main camera module and an extra-wide angle camera module, and the device housing is provided with a second assembly space, at least one of the main camera module and the extra-wide angle camera module being fixedly assembled in the second assembly space.

Optionally, in a thickness direction of the mobile terminal, a height section of the image sensor assembly is different from a height section of at least one of the main camera module and the extra-wide angle camera module,
and/or, in a direction perpendicular to the thickness direction of the mobile terminal, the main camera module and the extra-wide angle camera module are arranged on two sides of the image sensor module,
and/or, the light-permeable portion covers the second assembly space, and the first assembly space is communicated with the second assembly space.

According to a second aspect of the disclosure, a mobile device is provided, including: an external lens assembly and the mobile terminal as defined in the claims, the external lens assembly is detachably assembled with an external connection portion, positioned and installed on an external connection region of the mobile terminal.

Optionally, the external lens assembly includes an external lens and an adapter; the adapter is detachably connected to the external lens and the mobile terminal respectively, and the adapter includes a first positioning connection end positioned and connected to the external connection portion and a second positioning connection end positioned and connected to the external lens, the first positioning connection end and the second positioning connection end are connection end communicated with each other, a distance from the surface of the photosensitive unit of the image sensor assembly to an access plane of the external lens is equal to a flange focal distance of the external connection region lens,
and/or, the adapter comprises a first conductive contact and a second conductive contact, the first conductive contact being electrically connected to a main board of the mobile terminal, and the second conductive contact being electrically connected to the external lens,
and/or, the adapter includes a light-permeable opening matched with the light-permeable portion, the light-permeable opening matching the photosensitive unit of the image sensor assembly in structural shape and size.

The technical solutions provided by the disclosure at least may achieve the following beneficial effects:

According to the disclosure, a device housing of the mobile terminal includes a light-permeable portion and an external connection portion, and through the external connection portion, an external lens assembly can be positioned and mounted on the external connection region of the mobile terminal, and can cooperate with an image sensor module arranged inside a first assembly space in the device housing to achieve a shooting function. As the external lens assembly is detachably connected to the outside of the mobile terminal, an occupation of an internal space of the mobile terminal is avoided, and the lightness and thinness of the mobile terminal are improved. The image sensor assembly with a thinner structure and size built in the mobile terminal is helpful to enlarge an imaging size of the image sensor assembly to achieve an outsole imaging, and can achieve functions of a high computing power image processing, an editing and a sharing with the help of a platform of the mobile terminal, and cooperates with the external lens assembly to achieve a good shooting effect.

### BRIEF DESCRIPTION OF THE DRAWINGS

FIG. 1 is a schematic top view structural diagram of a mobile terminal according to an embodiment of the disclosure,
FIG. 2 is a schematic partial sectional structural diagram of a mobile terminal shown in an embodiment of the disclosure,
FIG. 3 is a schematic partial sectional structural diagram of a mobile terminal shown in another embodiment of the disclosure,
FIG. 4 is a schematic partial sectional structural diagram of a mobile terminal shown in another embodiment of the disclosure,
FIG. 5 a schematic partial sectional structural diagram of an image sensor assembly according to an embodiment of the disclosure,
FIG. 6 is a schematic top view structural diagram of a mobile terminal according to another embodiment of the disclosure,
FIG. 7 is a schematic partial sectional structural diagram of a mobile terminal shown in a further embodiment of the disclosure,
FIG. 8 is a schematic partial sectional structural diagram of a mobile terminal shown in still another embodiment of the disclosure,
FIG. 9 is a schematic perspective structural diagram of a mobile terminal according to an embodiment of the disclosure,
FIG. 10 is a schematic perspective structural diagram of a mobile terminal according to another embodiment of the disclosure,
FIG. 11 is a schematic distribution structural diagram of main camera assembly, an extra-wide angle camera assembly, and an image sensor assembly according to an embodiment of the disclosure,
FIG. 12 is a schematic exploded structural diagram of a mobile device according to an embodiment of the disclosure,
FIG. 13 is a schematic exploded structural diagram of an adapter according to an embodiment of the disclosure,
FIG. 14 is a schematic perspective structural diagram of an adapter according to an embodiment of the disclosure,
FIG. 15 is a schematic exploded structural diagram of a mobile device according to another embodiment of the disclosure.

### DETAILED DESCRIPTION

The embodiments will be described in detail here, and examples thereof are shown in the accompanying drawings. When the following descriptions refer to the drawings, the same numbers in different drawings indicate the same or similar elements, unless otherwise indicated. The implementation manners described in the following embodiments do not represent all implementation manners consistent with the disclosure. Instead, they are the examples of apparatuses and methods consistent with some aspects of the disclosure.

The terms used in the disclosure are for the purpose of describing specific embodiments, and are not intended to limit the disclosure. Technical or scientific terms used in the disclosure should have the ordinary meanings as understood by those of ordinary skill in the art to which the disclosure belongs, unless otherwise defined. The terms "first", "second" and the like used in the disclosure do not indicate any sequence, quantity or importance, and are used to distinguish between different components. Likewise, the terms "one" or "a/an" and the like do not indicate a limitation of quantity, but rather indicates the presence of at least one, and if only "one" is referred to, it will be stated separately. "A plurality of" or "several" indicates two or more. Unless otherwise indicated, the terms "front", "back", "lower" and/or "upper", "top", "bottom" and the like are used for ease of description and are not limited to one position or one spatial orientation. The terms "comprise" or "include" and the like are intended to indicate that an element or item preceding a "comprise" or an "include" encompasses the elements or items listed following the "comprise" or the "include", and equivalents thereof, but does not exclude another element or item. The terms "connected to" or "in connection with" and the like are not limited to physical or mechanical connections, and may include electrical connections, whether direct or indirect.

Mobile terminals such as mobile phones generally include a built-in camera module to achieve a shooting function. The camera module is integrated in the body of the mobile terminal, including an image sensor, a lens, a focusing module, an anti-shake motor and other main components, so as to obtain a good imaging picture quality in a limited space. However, in the related art, the structure and size of the built-in camera module of the mobile terminal are limited by the overall size of the mobile terminal. If the overall layout of the mobile terminal is considered, the function and imaging quality of the built-in camera module cannot be improved. If the camera module is too thick, the overall thickness of the mobile terminal may be large, the aesthetics and a use experience may be reduced, and a layout area of a main board of the mobile terminal and installation spaces of other components such as a battery capacity may also be affected.

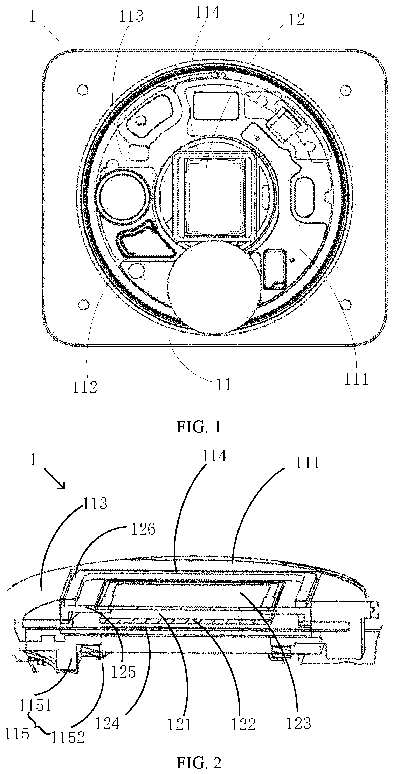

The disclosure provides a mobile terminal, and FIG. 1 is a schematic top view structural diagram of a mobile terminal according to an embodiment of the disclosure. As shown in FIG. 1, the mobile terminal 1 includes a device housing 11 and an image sensor assembly 12. The device housing 11 includes a light-permeable portion 111 and an external connection portion 112. A first assembly space 114 corresponding to the light-permeable portion 111 is arranged inside the device housing 11. Through the external connection portion 112, an external lens assembly 2 is capable of being positioned and mounted on the external connection region 113 outside the mobile terminal 1. The image sensor assembly 12 is arranged inside the first assembly space 114 and a photosensitive unit 121 of the image sensor assembly 12 corresponds to the external connection region 113.

It should be noted that the first assembly space 114 corresponding to the light-permeable portion means that the first assembly space 114 is located in the beneath region of the light-permeable portion 114, or the light-permeable portion 114 cover the first assembly space 114. As the image sensor assembly 12 is accommodated in the first assembly space 114, the light-permeable portion 111 may cover the area of the image sensor assembly 12, or may cover the area of the photosensitive unit 121 of the image sensor assembly 12, or may cover the image sensor assembly 12 and the peripheral area of the image sensor assembly 12, to allow the structural devices can be seen through the light-permeable portion 111, and improve the technological sense and aesthetics of the mobile terminal 1. Similarly, the external connection region 113 is arranged at least to cover a photosensitive unit 121 of the image sensor assembly 12 means the external connection region 113 may cover the area of the photosensitive unit 121 of the image sensor assembly 12, or may cover the area of the image sensor assembly 12, or may cover the image sensor assembly 12 and the peripheral area of the image sensor assembly 12, so that the effective penetration of light is still ensured after the external lens assembly 2 installed.

As the device housing 11 of the mobile terminal 1 includes the light-permeable portion 111 and the external connection portion 112, and through the external connection portion 112, the external lens assembly 2 can be positioned and installed on the external connection region 113 outside the mobile terminal 1. The external lens assembly 2 can cooperate with the image sensor assembly 12 arranged in the first assembly space 114 in the device housing 11 to achieve a shooting function. The external lens assembly 2 is detachably connected to the outside of the mobile terminal 1, such that an occupation of an internal space of the mobile terminal 1 is avoided, and the lightness and thinness of the mobile terminal 1 are improved. The image sensor assembly 12 with a thinner structure built in the mobile terminal 1 is helpful to enlarge an imaging size of the image sensor assembly 12 to achieve an outsole imaging and obtain half-frame and full-frame images. The image sensor assembly 12 can achieve functions of a high computing power image processing, an editing and a sharing with the help of a platform of the mobile terminal 1, and cooperates with the external lens assembly 2 to achieve a good shooting effect.

In addition, since the external lens assembly 2 does not occupy the internal space of the mobile terminal 1, and a main board of the mobile terminal 1 is no longer limited by a lens size, an improved layout area can be obtained, and a heat dispersion effect and the integrity of a transmitted signal can be improved. Moreover, the internal space of the mobile terminal 1 saved by externally connecting the lens can also be used to improve a battery capacity and increase the endurance of the mobile terminal 1.

A distance from the photosensitive main body 121 of the image sensor assembly 12 to the light-permeable portion 111 of the device housing 11 is relatively small, and the distance can be less than or equal to 10 mm, so that almost all common lenses in the market can be adapted, and make one mobile terminal 1 adapted to various lenses, so that the photographing experience of a photography enthusiast is improved. Traditional lens can also rely on the above mobile terminal 1 to play a role, and the mobile terminal 1 can also serve as a professional photography tool in addition to having a communication function, and has higher value.

It should be noted that the mobile terminal 1 may be a mobile phone, a tablet computer, a wearable device, etc., which is not limited by the disclosure. For example, the mobile terminal 1 is a mobile phone, the mobile phone has a high computing power platform, high-efficiency and high-quality image algorithms, and convenient editing and sharing functions. After collecting light through the external lens assembly 2 and imaging through the image sensor assembly 12, the mobile phone can be directly used to perform image processing, editing and sharing, so that a convenient image system is obtained, and a process is avoided that when a camera with a high imaging quality is separately used, an image needs to be transferred out and then processed, edited and shared.

For example, in scenarios such as traveling, professional photography, and interview video recording, it is no longer necessary to carry a heavy camera body other than a camera lens for daily use. It is only necessary to install the camera lens on the mobile terminal 1 for use, and disassemble the camera lens after use, so that the portability and convenience of use are improved.

Since selection of the external lens assembly 2 is no longer limited by an assembly space of the mobile terminal 1, the external lens 22 can match the imaging size of the image sensor assembly 12 to the maximum extent, and many performances such as an aperture, a light inlet amount, and resolution power can be improved. For example, when shooting in dark scenarios such as a night, a dark room, a cave, and a tunnel, the external lens 22 with a large diameter and aperture can be selected, and an exposure and a fusion algorithms of the mobile terminal 1 can be combined to obtain good dark state scenario photos and improve the user experience.

In another example, the photography enthusiast can externally connect, according to a shooting scenario and a shooting need, a lens of a single-lens reflex camera, a micro-single digital camera or a film camera, such as a telephoto portrait lens, an extra-wide angle landscape lens, a large aperture lens, a cinema lens. The above external lens 22 is combined with the image sensor assembly 12 built in the mobile terminal 1 to complete functions such as taking pictures and videos, thus improving the quality of pictures and videos. The above mobile terminal 1 can further be externally connected to some old lenses with difficult field distance matching collected by the photography enthusiast, so that the practicability of the old lenses is improved.

Because the image sensor assembly 12 of the mobile terminal 1 is smaller than an image sensor of a traditional camera, when the mobile terminal 1 adapts to the external lens 22 with different specifications, an equivalent conversion needs to be performed on a lens focal length. For example, the size of the image sensor assembly 12 of the mobile terminal 1 is 1 inch, and a diagonal line length ratio of the image sensor of a full-frame camera to the image sensor assembly 12 of the mobile terminal in the disclosure is 43.27/16=2.7, and 2.7 is the focal length conversion coefficient of the external lens 22 of the full-frame camera. When using a full-frame 50 mm focal length external lens 22, an equivalent focal length is 50 mm*2.7=135 mm. Similarly, for an APS-C camera lens, the focal length conversion coefficient is 28.3/16=1.77. For a 4/3-inch camera lens, the focal length conversion coefficient is 22.4/16=1.4. According to the above focal length conversion coefficients, the corresponding external lens 22 can be selected according to a shooting scenario.

In some embodiments, as shown in FIG. 2, the device housing 11 may include a first bracket 115. The first bracket 115 includes a bracket body 1151 and a first accommodation space 1152 surrounded by the bracket body 1151, and the image sensor assembly 12 is assembled in the first accommodation space. The image sensor assembly 12 is assembled and fixed by the first bracket 115, improving the installation convenience, stability and structural reliability of the image sensor assembly 12.

It should be noted that the first accommodating space 1152 may be smaller than or equal to the first assembly space 114. For example, in an embodiment including the first bracket 115 in FIG. 2, the first bracket 115 is accommodated in the first assembly space 114, and the first accommodation space 1152 surrounded by the bracket body 1151 for assembling the image sensor module 12. In this case, the first accommodating space 1152 is smaller than the first assembling space 114. In some other embodiments, in an embodiment that does not include the first bracket 115, the image sensor assembly 12 can be directly assembled in the first assembly space 114. In this case, it can be considered that the first accommodating space 1152 is equivalent to the assembly spaces 114 are equal.

In the above embodiment, the bracket body 1151may include a heat dissipation structure 1153, and at least a part of the image sensor assembly 12 is in a contacting fit with the heat dissipation structure 1153, and heat dissipation function of the image sensor assembly 12 is achieved by the bracket body 1151, so that the first bracket 115 not only has a function of supporting and assembling, but also has the heat dissipation function for the image sensor assembly 12.

It should be noted that, the heat dissipation structure 1153 may be made of a metal material to export heat from the image sensor assembly 12 through contact between the metal material and the image sensor assembly 12 and another peripheral metal member. The bracket main body may be molded by injection molding to obtain a structure including a metal and a plastic material.

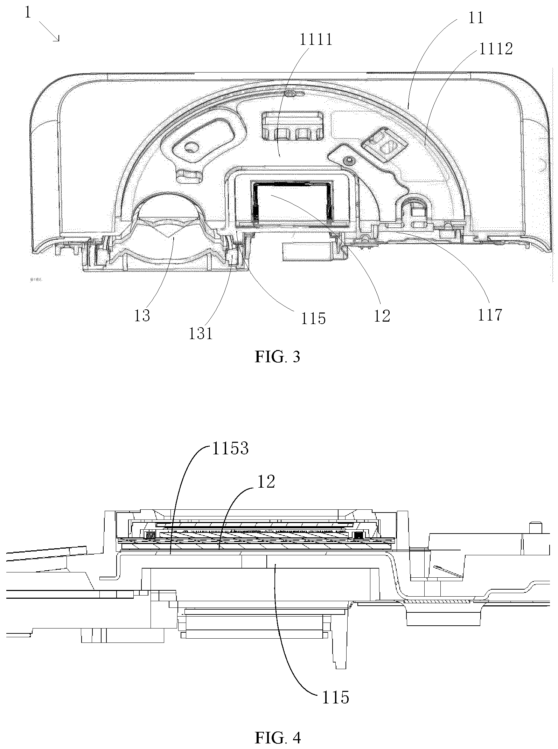

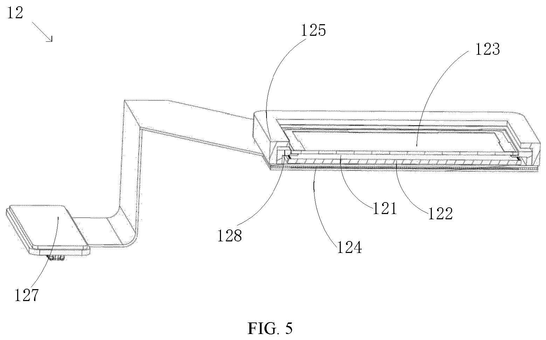

In some embodiments, as shown in FIGs 2 to 5, the image sensor assembly 12 may include an optical filter 123, a sensor body 122, and a circuit board 124. The optical filter 123 is arranged above the sensor body 122 and covers a photosensitive unit 121 of the sensor body 122, the circuit board 124 is arranged below the sensor body 122. The optical filter 123 may be supported by a third bracket 128 to improve the assembly stability thereof.

When the image sensor assembly 12 is assembled in the first accommodation space of the first bracket 115, the heat dissipation structure 1153 may be located at the bottom of the bracket body, so that the circuit board 124 of the image sensor assembly 12 may be in direct contact with the heat dissipation structure 1153, thereby achieving the heat dissipation function to the image sensor assembly 12.

As the optical filter 123 covers the photosensitive unit 121 of the sensor body 122, the optical filter 123 can be visually seen through the light-permeable portion 111, improving the science and technology feeling and aesthetics of the mobile terminal 1.

In some embodiments, the image sensor assembly 12 may further include a protective cover 125 and a sealing member 126. The protective cover 125 covers edge regions of the optical filter 123, the sensor body 122 and the circuit board 124. The light-permeable portion 111 includes and a light-permeable cover plate 1112. The sealing member 126 is arranged at an edge region between the light-permeable cover plate 1112 and the protective cover 125, and is respectively in a sealing fit with the light-permeable cover plate 1112 and the protective cover 125. The protective cover 125 can protect the image sensor assembly 12, and prevent same from moving or damage due to the shaking or collision of the mobile terminal 1 during use. The protective cover 125 can also cooperate with the sealing member 126 to seal the image sensor assembly 12 to prevent dust, impurities or liquid from entering the image sensor assembly 12 and affecting imaging.

It should be noted that, the above sealing member 126 may be a foam, a double-sided adhesive, a sealant, or a silicone pad, which is not limited by the disclosure. In addition, light leakage can be prevented by silkscreen at the contact region of the third bracket 128 and the optical filter 123, so that ghost and flare are avoided.

In the above embodiment, the size of the photosensitive unit 121 of the image sensor assembly 12 is greater than or equal to 16 mm, so as to obtain an outsole imaging effect.

In some embodiments, when the mobile terminal 1 includes a built-in camera module, the first bracket 115 may be assembled on a second bracket 131 supporting the built-in camera module to make the second bracket 131 support the first bracket 115, thereby improving the structural stability of the first bracket 115.

In the above embodiment, an example installation process of the mobile terminal 1 may be implemented by the following steps: firstly a connector 127 of the image sensor assembly 12 is buckled on a top surface of the main board of the mobile terminal 1, and the connector 127 is installed in a middle frame 116 together with the main board. Then, the head of the image sensor assembly 12 passes through the second bracket 131, and the connector 127 of the built-in camera module is buckled to the main board, and then an antenna cover 117 is assembled, and is fixed by locking screws. Next, the first bracket 115 is assembled on the second bracket 131, the image sensor assembly 12 is fixed in the first accommodation space of the first bracket 115, all protective films are torn off, and the mobile terminal 1 is covered with an integrated back housing, and the integrated back housing may include a decorative cover plate 14 and a battery cover. Finally, the battery cover is subjected to pressure maintaining and then enters a testing station for testing.

In some other embodiments, the mobile terminal 1 further includes the antenna cover 117, the first bracket 115 and the antenna cover 117 are integrally formed to support the image sensor assembly 12 through the original antenna cover 117 of the mobile terminal 1. Thereby simplifying an internal structure of the mobile terminal 1, and improving the assembly convenience and use reliability of the first bracket 115.

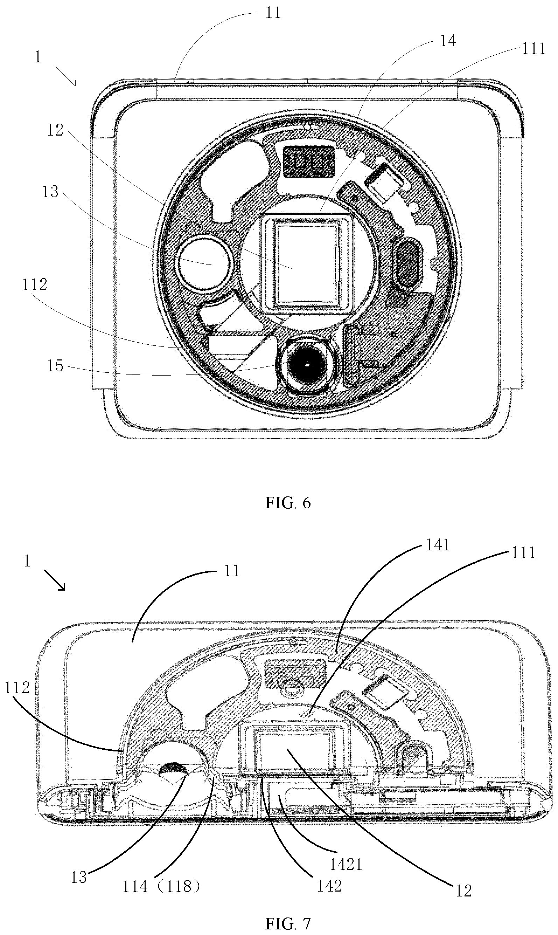

In some embodiments, as shown in FIGs 6 to 8, the device housing 11 includes a middle frame 116 and a decorative cover plate 14 assembled in the middle frame 116, and the external connection portion 112 is arranged on the decorative cover plate 14. The decorative cover plate 14 can be used to decorate the light-permeable portion 111 to improve the external aesthetics of the mobile terminal 1 having the image sensor assembly 12. The external connection portion 112 is arranged on the decorative cover plate 14, so that the external aesthetics of the device housing 11 can be improved, and the connection strength between the external connection portion 112 and the external lens assembly 2 can also be improved.

In some embodiments, the image sensor assembly 12 may be assembled and fixed with the decorative cover plate 14 to assemble the image sensor assembly 12 through the decorative cover plate 14, thereby improving the alignment precision of the image sensor assembly 12 and an optical axis of the external lens 22.

The above decorative cover plate 14 may include a cover plate body 141 and an installing structure 142, the cover plate body 141 is arranged at a periphery of the light-permeable portion 111 and covers at least a part of the structure of the mobile terminal 1. The installing structure 142 surrounds and forms a second accommodation space 1421 inside the mobile terminal 1, and the image sensor assembly 12 is assembled in the second accommodation space 1421. By means of the above structure, an alignment dimension chain between the image sensor assembly 12 and the external lens 22 can be shortened and the alignment precision of the image sensor assembly 12 and the optical axis of the external lens 22 can be improved. Further, the structure of the mobile terminal 1 can be simplified by using the structure of the existed decorative cover plate 14 of the mobile terminal 1.

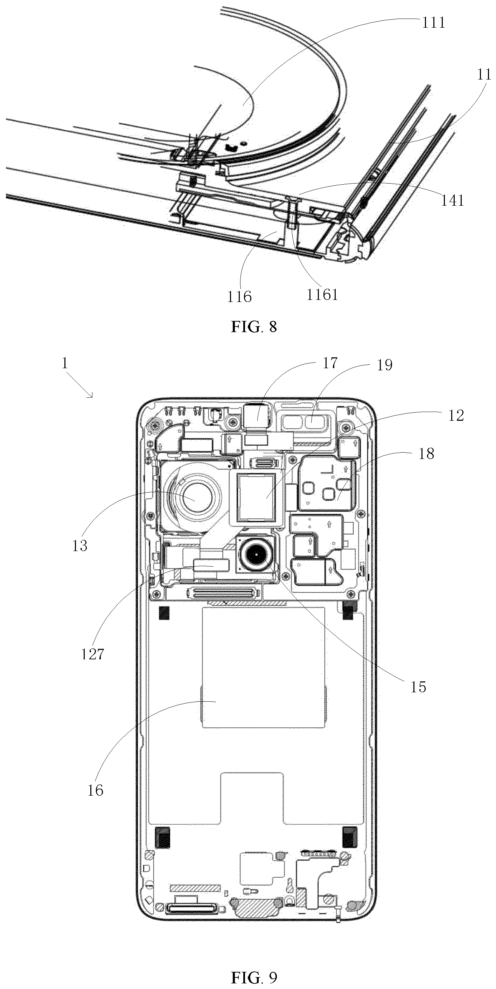

As shown in FIG. 8, the mobile terminal 1 may further include a plurality of threaded connection members 1161. The decorative cover plate 14 and the middle frame 116 are fixed by using the threaded connection members 1161 to improve the structural strength of the decorative cover plate 14 and provide a reliable structural basis for installation of the external lens assembly 2. For example, four corners of the decorative cover plate 14 may be respectively provided with the threaded connection member 1161 to be fixed with the middle frame 116 through the threaded connection member 1161.

In the above embodiment, the example installation process of the mobile terminal 1 may be implemented by the following steps: firstly the connector 127 of the image sensor assembly 12 is buckled on the top surface of the main board, and the connector 127 is installed in the middle frame 116 together with the main board. Then, the head of the image sensor assembly 12 passes through the second bracket 131, and the connector 127 of the built-in camera module is buckled to the main board. Then, the rear antenna cover 117 is assembled, and is fixed by locking screws, and a protective film of the built-in camera module is taken off. Finally, the image sensor assembly 12 is fixed in the second accommodation space of the decorative cover plate 14, a protective film of the image sensor assembly 12 is taken off, the battery cover with the decorative cover plate 14 is preliminarily fixed on the middle frame 116, a lens of the decorative cover plate 14 is assembled to the decorative cover plate 14, and the lens and the battery cover are subjected to pressure maintaining and then enter the test station for testing.

In the above embodiment, the external connection portion 112 may include at least one of a clamping structure, a threaded connection structure and a magnetic connection structure arranged in the device housing 11, so as to achieve disassembly and assembly convenience of the external lens 22 by means of a detachable connection between the external connection portion 112 and the external lens assembly 2.

In some embodiments, the mobile terminal 1 may further include a decorative cover body assembled outside the device housing 11, and the decorative cover body covers at least one of light-permeable portion 111 and the external connection portion 112 to shield the light-permeable portion 111 and/or the external portion 112 when the external lens assembly 2 is not installed, thereby improving the overall aesthetics of the mobile terminal 1.

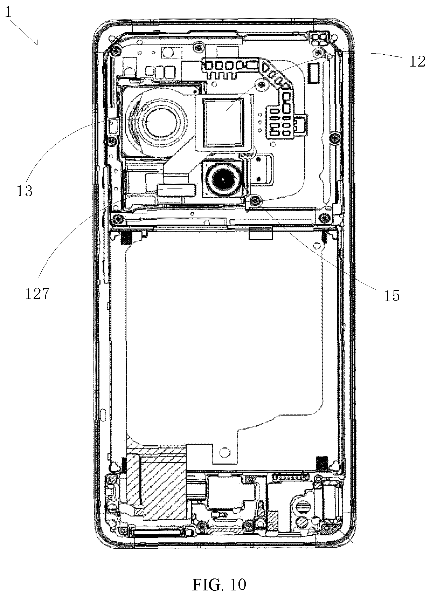

In some embodiments, as shown in FIGs 7 to 11, the mobile terminal 1 may further include at least one of a main camera module 13 and an extra-wide angle camera module 15, the device housing 11 is provided with a second assembly space 118, and the main camera module 13 and the extra-wide angle camera module 15 are fixedly assembled in the second assembly space 118. During daily use, the main camera module 13 and the extra-wide angle camera module 15 can achieve a single camera shooting function such as code scanning, simple photographing, and the dual-camera portrait mode function can also be completed.

It should be noted that the size of the photosensitive unit 121 of an image sensor of the main camera module 13 and/or the extra-wide angle camera module 15 may be greater than or equal to 1 inch to improve an imaging effect of the built-in camera module of the mobile terminal 1. When the size of the photosensitive main body 121 of the main camera module 13 and the image sensor assembly 12 is 1 inch, an imaging quality is improved, layout placement of the camera module is facilitated, and the space utilization rate is improved.

In the above embodiment, in a thickness direction of the mobile terminal 1, a height section of the image sensor assembly 12 is different from that of at least one of the main camera assembly 13 and the extra-wide angle camera module 15, so as to avoid structural interference between the image sensor assembly 12 and the main camera module 13 and/or the extra-wide angle camera module 15 and improve the utilization rate of the internal space of the mobile terminal 1.

In a perpendicular to the thickness direction of the mobile terminal 1, the main camera module 13 and the extra-wide angle camera module 15 can be arranged on two sides of the image sensor assembly 12, so as to facilitate the lighting of the image sensor assembly 12 and improve the layout aesthetics of an imaging structure. The main camera module 13 and the extra-wide angle camera module 15 can be arranged on two sides of the image sensor assembly 12, and the two sides can refer to any two sides of the image sensor assembly 12. For example, the main camera module 13 can be arranged on the left side of the image sensor assembly 12, and the extra-wide angle camera module 15 can be arranged on the lower side of the image sensor assembly 12.

The main camera module 13, the extra-wide angle camera module 15 and the image sensor assembly 12 adopt the above layout to optimize the internal structure of the mobile terminal 1, and increase an installation space of functional modules such as a battery 16, an earpiece assembly 19, a main board processor 18 and a front camera module 17.

The light-permeable portion 111 can cover the second assembly space, and the first assembly space 114 is communicated with the second assembly space 118. That is, the main camera module 13 and/or the extra-wide angle camera module 15 and the image sensor assembly 12 may be arranged in the same space, and the above main camera module 13 and/or the extra-wide angle camera module 15 and the image sensor assembly 12 all obtain light through the light-permeable portion 111, so as to simplify the structural arrangement of the mobile terminal 1 and improve the aesthetics of the mobile terminal 1.

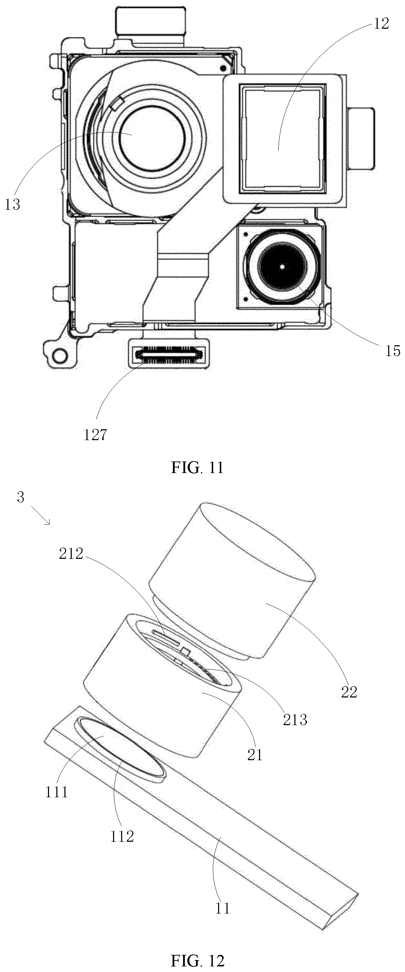

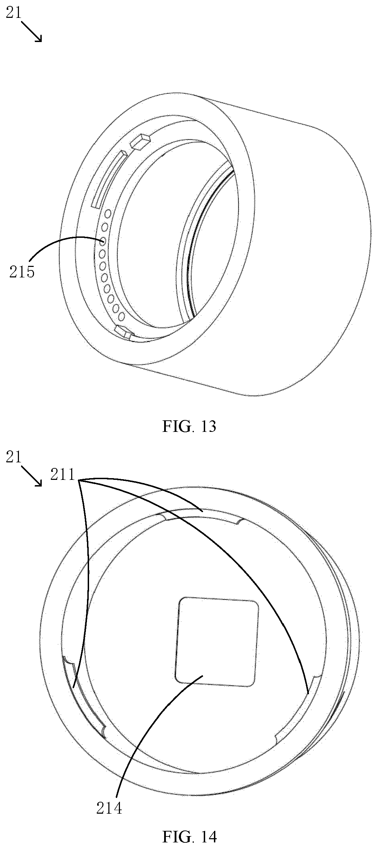

The disclosure further provides a mobile device 3, as shown in FIGs 12 to 14, the mobile device 3 includes an external lens assembly 2 and a mobile terminal according to any embodiment of above, where the external lens assembly 2 is detachably assembled with the external connection portion 112, to be positioned and installed on the external connection region 113 of the mobile terminal 1.

As the device housing 11 of the mobile terminal 1 includes the light-permeable portion 111 and the external connection portion 112, and through the external connection portion 112, the external lens assembly 2 can be positioned and installed on the external connection region 113 outside the mobile terminal 1, and the external lens assembly 2 can cooperate with the image sensor assembly 12 arranged in the first assembly space 114 in the device housing 11 to achieve a shooting function. Since the external lens assembly 2 is detachably connected to the outside of the mobile terminal 1, such that an occupation of an internal space of the mobile terminal 1 is avoided, and the lightness and thinness of the mobile terminal 1 are improved. The image sensor assembly 12 with a thinner structure built in the mobile terminal 1 is helpful to enlarge an imaging size of the image sensor assembly 12 to achieve an outsole imaging, and can achieve functions of a high computing power image processing, an editing and a sharing with the help of a platform of the mobile terminal 1, and cooperates with the external lens assembly 2 to achieve a good shooting effect.

In some embodiments, the external lens assembly 2 includes an external lens 22 and an adapter 21, the adapter 21 is detachably connected to the external lens 22 and the mobile terminal 1 respectively. The adapter 21 includes a first positioning connection end 211 and a second positioning connection end 212 communicated with each other. The first positioning connection end 211 being positioned and connected to the external connection portion 112, and the second positioning connection end 212 being positioned and connected to the external lens 22. Thus, the distance from the surface of a photosensitive main 121 of the image sensor assembly 12 to an access plane of the external lens 22 is equal to a flange focal distance of the external lens 22.

A plurality of second positioning connection ends 212 matching a flange focal distance of different external lenses 22 may be provided for the adapter 21, so that the external lenses 22 having different flange focal distances can be installed to the mobile terminal 1 and can focus and be used normally. A corresponding adapter 21 may also be provided for different external lenses 22, so that the second positioning connection end 212 of each adapter 21 is positioned and connected to the external lens 22 to obtain a flange focal distance matching the external lens 22.

In the above embodiment, the adapter 21 includes first conductive contacts 215 and second conductive contacts 213, the first conductive contacts 215 being electrically connected to a main board of the mobile terminal 1, and the second conductive contacts 213 being electrically connected to the external lens 22. The external lens 22 may include functions such as automatic focusing, anti-shake. After the mobile terminal 1 and the external lens 22 are electrically connected through the adapter 21, a control signal or a feedback signal may be transmitted to each other, so as to achieve focusing and anti-shake by using functions such as automatic focusing and anti-shake of the external lens 22, thereby improving the focusing and anti-shake effects of the mobile terminal 1.

The adapter 21 may include a light-permeable opening 214 in a fit with the light-permeable portion 111, the light-permeable opening 214 matching the photosensitive unit 121 of the image sensor assembly 12 in structural shape and size. The light-permeable opening 214 of the adapter 21 can transmit the light passing through the external lens 22 to the photosensitive unit 121 of the image sensor assembly 12 through the light-permeable opening 214, and the light-permeable opening 214 matches the photosensitive unit 121 in structural shape and size to prevent external scatter light from entering the image sensor assembly 12 to affect the imaging effect. For example, when the photosensitive unit 121 is rectangular, the light-permeable opening 214 may be rectangular matching the photosensitive unit 121, such that after the external lens 22 is assembled to the mobile terminal 1, the photosensitive unit 121 obtain better lighting and imaging effects.

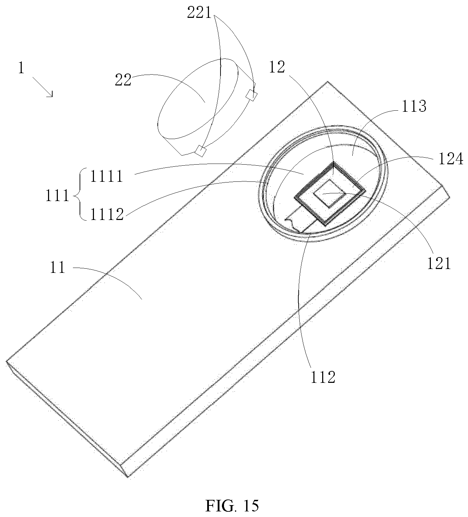

In some other embodiments, as shown in FIG. 15, the external lens assembly 2 may only include the external lens 22, and the external lens 22 is provided with a connection structure 221 detachably connected to the external connection portion 112 to achieve an assembly of the external lens 22 and the mobile terminal 1.

## Claims

1. A mobile terminal, comprising:
a device housing (11), comprising a light-permeable portion (111) and an external connection portion (112) whereby an external lens assembly is able to be positioned and mounted on the external connection region (113) of the mobile terminal (1), wherein a first assembly space (114) corresponding to the light-permeable portion (111) is arranged inside the device housing (11), and
an image sensor assembly (12) is arranged inside the first assembly space (114), wherein the external connection region (113) is arranged at least to cover a photosensitive unit of the image sensor assembly 12,
wherein the image sensor assembly (12) is **characterized in** comprising an optical filter (123), a sensor body (122), and a circuit board (124), the optical filter (123) is arranged above the sensor body (122) and covers the photosensitive unit (121) of the sensor body (122), and the circuit board (124) is arranged below the sensor body (122),
wherein the image sensor assembly further comprises a protective cover (125) and a sealing member (126), the protective cover(125) covers edge regions of the image sensor assembly (12), the light-permeable portion(111) comprises a light-permeable cover plate (1112), wherein the sealing member (126) is arranged at an edge region between the light-permeable cover plate (1112) and the protective cover (125), and is respectively in a sealing fit with the light-permeable cover plate (1112) and the protective cover (125).

2. The mobile terminal according to claim 1, wherein the device housing (11) comprises a first bracket (115) comprising a bracket body (1151) and a first accommodation space (1152) surrounded by the bracket body (1151), and the image sensor assembly (12) is assembled in the first accommodation space (1152).

3. The mobile terminal according to claim 2, wherein the bracket body (1151) comprises a heat dissipation structure (1153), and at least a part of the image sensor assembly (12) is in a contacting fit with the heat dissipation structure (1153).

4. The mobile terminal according to claims 2 or 3, wherein the mobile terminal (1) further comprises an antenna cover (117) integrally formed with the first bracket (115).

5. The mobile terminal according to any one of claims 1 to 4, wherein the device housing (11) comprises a middle frame (116) and a decorative cover plate (14) assembled in the middle frame (116), and the external connection portion (112) is arranged on the decorative cover plate (14).

6. The mobile terminal according to claim 5, wherein the image sensor assembly (12) is assembled and fixed with the decorative cover plate (14), optionally, the decorative cover plate (14) comprises a cover plate body (141) and an installing structure (142), wherein the cover plate body (141) is arranged at a periphery of the light-permeable portion (111) and covers at least a part of the mobile terminal (1), and the installing structure surrounds (142) and forms a second accommodation space (1421) inside the mobile terminal (1), wherein the image sensor assembly (12) is assembled in the second accommodation space (1421).

7. The mobile terminal according to claim 5, wherein the mobile terminal (1) further comprises a plurality of threaded connection members (1161), the decorative cover plate (14) and the middle frame (116) are fixed by the threaded connection members (1161).

8. The mobile terminal according to any one of claims 1 to 7, wherein the size of the photosensitive unit (121) of the image sensor assembly (12) is greater than or equal to 16 mm.

9. The mobile terminal according to any one of claims 1 to 8, wherein the external connection portion (112) comprises at least one of a clamping structure, a threaded connection structure and a magnetic connection structure arranged in the device housing (11).

10. The mobile terminal according to any one of claims 1 to 9, wherein the mobile terminal (1) further comprises a decorative cover body assembled outside the device housing (11) and covering at least one of the light-permeable portion (111) and the external connection portion (112).

11. The mobile terminal according to any one of claims 1 to 10, wherein the mobile terminal (1) further comprises at least one of a main camera module (13) and an extra-wide angle camera module (15), and the device housing (11) is provided with a second assembly space (118), at least one of the main camera module (13) and the extra-wide angle camera module (15) being fixedly assembled in the second assembly space (118).

12. The mobile terminal according to claim 11, wherein in a thickness direction of the mobile terminal (1), a height section of the image sensor assembly (12) is different from a height of at least one of the main camera module (13) and the extra-wide angle camera module (15),
and/or, in a direction perpendicular to the thickness direction of the mobile terminal (1), the main camera module (13) and the extra-wide angle camera module (15) are arranged on two sides of the image sensor assembly (12),
and/or, the light-permeable portion (111) covers the second assembly space (118), and the first assembly space (114) is communicated with the second assembly space (118).

13. A mobile device, comprising: an external lens assembly (2) and the mobile terminal (1) according to any one of claims 1 to 12, the external lens assembly (2) is detachably assembled with an external connection portion (112), positioned and installed on an external connection region (113) of the mobile terminal (1).

14. The mobile device according to claim 13, wherein the external lens assembly (2) comprises an external lens (22) and an adapter (21), the adapter (21) is detachably connected to the external lens (22) and the mobile terminal (1) respectively, and the adapter (21) comprises a first positioning connection end (211) positioned and connected to the external connection portion (112) and a second positioning connection end (212) positioned and connected to the external lens (22), the first positioning connection end and the second positioning connection end (212) are communicated with each other, and a distance from the surface of the photosensitive unit (121) of the image sensor assembly (12) to an access plane of the external lens (22) is equal to a flange focal distance of the external lens (22),
and/or, the adapter (21) comprises a first conductive contact (215) and a second conductive contact (213), the first conductive contact (215) being electrically connected to a main board of the mobile terminal (1), and the second conductive contact (213) being electrically connected to the external lens (22),
and/or, the adapter (21) comprises a light-permeable opening (214) matched with the light-permeable portion (111), the light-permeable opening (214) matching the photosensitive unit of the image sensor assembly (12) in structural shape and size.

## Patentansprüche

1. Mobiles Endgerät, umfassend:
ein Vorrichtungsgehäuse (11), das einen lichtdurchlässigen Abschnitt (111) und einen externen Verbindungsabschnitt (112) umfasst, wodurch eine externe Linsenbaugruppe an dem externen Verbindungsbereich (113) des mobilen Endgeräts (1) positioniert und angebracht werden kann, wobei ein erster Montageraum (114), der dem lichtdurchlässigen Abschnitt (111) entspricht, innerhalb des Vorrichtungsgehäuses (11) angeordnet ist, und
eine Bildsensorbaugruppe (12) innerhalb des ersten Montageraums (114) angeordnet ist, wobei der externe Verbindungsbereich (113) zumindest so angeordnet ist, dass er eine fotoempfindliche Einheit der Bildsensorbaugruppe (12) abdeckt,
wobei die Bildsensorbaugruppe (12) **dadurch gekennzeichnet ist, dass** sie ein optisches Filter (123), einen Sensorkörper (122) und eine Leiterplatte (124) umfasst, wobei das optische Filter (123) über dem Sensorkörper (122) angeordnet ist und die fotoempfindliche Einheit (121) des Sensorkörpers (122) abdeckt und die Leiterplatte (124) unter dem Sensorkörper (122) angeordnet ist,
wobei die Bildsensorbaugruppe ferner eine Schutzabdeckung (125) und ein Dichtungselement (126) umfasst, wobei die Schutzabdeckung (125) Randbereiche der Bildsensorbaugruppe (12) abdeckt, wobei der lichtdurchlässige Abschnitt (111) eine lichtdurchlässige Abdeckplatte (1112) umfasst, wobei das Dichtungselement (126) an einem Randbereich zwischen der lichtdurchlässigen Abdeckplatte (1112) und der Schutzabdeckung (125) angeordnet ist und jeweils in Dichtungspassung mit der lichtdurchlässigen Abdeckplatte (1112) und der Schutzabdeckung (125) steht.

2. Mobiles Endgerät nach Anspruch 1, wobei das Vorrichtungsgehäuse (11) eine erste Halterung (115) umfasst, die einen Halterungskörper (1151) und einen ersten Aufnahmeraum (1152), der vom Halterungskörper (1151) umschlossen ist, umfasst, und die Bildsensorbaugruppe (12) im ersten Aufnahmeraum (1152) montiert ist.

3. Mobiles Endgerät nach Anspruch 2, wobei der Halterungskörper (1151) eine Wärmeableitungsstruktur (1153) umfasst und sich zumindest ein Teil der Bildsensorbaugruppe (12) in Kontaktpassung mit der Wärmeableitungsstruktur (1153) befindet.

4. Mobiles Endgerät nach den Ansprüchen 2 oder 3, wobei das mobile Endgerät (1) ferner eine Antennenabdeckung (117) umfasst, die integral mit der ersten Halterung (115) ausgebildet ist.

5. Mobiles Endgerät nach einem der Ansprüche 1 bis 4, wobei das Vorrichtungsgehäuse (11) einen Mittelrahmen (116) und eine im Mittelrahmen (116) montierte dekorative Abdeckplatte (14) umfasst und der externe Verbindungsabschnitt (112) auf der dekorativen Abdeckplatte (14) angeordnet ist.

6. Mobiles Endgerät nach Anspruch 5, wobei die Bildsensorbaugruppe (12) mit der dekorativen Abdeckplatte (14) montiert und befestigt ist, optional wobei die dekorative Abdeckplatte (14) einen Abdeckplattenkörper (141) und eine Installationsstruktur (142) umfasst, wobei der Abdeckplattenkörper (141) an einem Umfang des lichtdurchlässigen Abschnitts (111) angeordnet ist und zumindest einen Teil des mobilen Endgeräts (1) abdeckt, und die Installationsstruktur (142) einen zweiten Aufnahmeraum (1421) innerhalb des mobilen Endgeräts (1) umschließt und bildet, wobei die Bildsensorbaugruppe (12) im zweiten Aufnahmeraum (1421) montiert ist.

7. Mobiles Endgerät nach Anspruch 5, wobei das mobile Endgerät (1) ferner mehrere Gewindeverbindungselemente (1161) umfasst, wobei die dekorative Abdeckplatte (14) und der Mittelrahmen (116) mittels der Gewindeverbindungselemente (1161) befestigt sind.

8. Mobiles Endgerät nach einem der Ansprüche 1 bis 7, wobei die Größe der fotoempfindlichen Einheit (121) der Bildsensorbaugruppe (12) größer oder gleich 16 mm ist.

9. Mobiles Endgerät nach einem der Ansprüche 1 bis 8, wobei der externe Verbindungsabschnitt (112) eine Klemmstruktur und/oder eine Gewindeverbindungsstruktur und/oder eine magnetische Verbindungsstruktur umfasst, die im Vorrichtungsgehäuse (11) angeordnet sind.

10. Mobiles Endgerät nach einem der Ansprüche 1 bis 9, wobei das mobile Endgerät (1) ferner einen dekorativen Abdeckkörper umfasst, der außerhalb des Vorrichtungsgehäuses (11) montiert ist und den lichtdurchlässigen Abschnitt (111) und/oder den externen Verbindungsabschnitt (112) abdeckt.

11. Mobiles Endgerät nach einem der Ansprüche 1 bis 10, wobei das mobile Endgerät (1) ferner ein Hauptkameramodul (13) und/oder ein Extra-Weitwinkel-Kameramodul (15) umfasst und das Vorrichtungsgehäuse (11) mit einem zweiten Montageraum (118) versehen ist, wobei das Hauptkameramodul (13) und/oder das Extra-Weitwinkel-Kameramodul (15) fest im zweiten Montageraum (118) montiert sind.

12. Mobiles Endgerät nach Anspruch 11, wobei sich in einer Dickenrichtung des mobilen Endgeräts (1) ein Höhenabschnitt der Bildsensorbaugruppe (12) von einer Höhe des Hauptkameramoduls (13) und/oder des Extra-Weitwinkel-Kameramoduls (15) unterscheidet,
und/oder in einer Richtung senkrecht zu der Dickenrichtung des mobilen Endgeräts (1) das Hauptkameramodul (13) und das Extra-Weitwinkel-Kameramodul (15) auf zwei Seiten der Bildsensorbaugruppe (12) angeordnet sind,
und/oder der lichtdurchlässige Abschnitt (111) den zweiten Montageraum (118) abdeckt und der erste Montageraum (114) mit dem zweiten Montageraum (118) in Verbindung steht.

13. Mobile Vorrichtung, umfassend: eine externe Linsenbaugruppe (2) und das mobile Endgerät (1) nach einem der Ansprüche 1 bis 12, wobei die externe Linsenbaugruppe (2) lösbar mit einem externen Verbindungsabschnitt (112) montiert, an einem externen Verbindungsbereich (113) des mobilen Endgeräts (1) positioniert und installiert ist.

14. Mobile Vorrichtung nach Anspruch 13, wobei die externe Linsenbaugruppe (2) eine externe Linse (22) und einen Adapter (21) umfasst, wobei der Adapter (21) jeweils lösbar mit der externen Linse (22) bzw. dem mobilen Endgerät (1) verbunden ist, und der Adapter (21) ein erstes Positionierungsverbindungsende (211), das mit dem externen Verbindungsabschnitt (112) positioniert und verbunden ist, und ein zweites Positionierungsverbindungsende (212), das mit der externen Linse (22) positioniert und verbunden ist, umfasst, wobei das erste Positionierungsverbindungsende und das zweite Positionierungsverbindungsende (212) miteinander in Verbindung stehen und ein Abstand von der Oberfläche der fotoempfindlichen Einheit (121) der Bildsensorbaugruppe (12) zu einer Zugangsebene der externen Linse (22) gleich einem Auflagemaß der externen Linse (22) ist,
und/oder der Adapter (21) einen ersten leitfähigen Kontakt (215) und einen zweiten leitfähigen Kontakt (213) umfasst, wobei der erste leitfähige Kontakt (215) elektrisch mit einer Hauptplatine des mobilen Endgeräts (1) verbunden ist und der zweite leitfähige Kontakt (213) elektrisch mit der externen Linse (22) verbunden ist,
und/oder der Adapter (21) eine lichtdurchlässige Öffnung (214) umfasst, die mit dem lichtdurchlässigen Abschnitt (111) übereinstimmt, wobei die lichtdurchlässige Öffnung (214) in struktureller Form und Größe mit der fotoempfindlichen Einheit der Bildsensorbaugruppe (12) übereinstimmt.

## Revendications

1. Terminal mobile, comprenant:
un boîtier de dispositif (11), comprenant une partie perméable à la lumière (111) et une partie de connexion externe (112) de sorte qu'un ensemble objectif externe puisse être positionné et monté sur la région de connexion externe (113) du terminal mobile (1), un premier espace d'assemblage (114) correspondant à la partie perméable à la lumière (111) étant ménagé à l'intérieur du boîtier de dispositif (11), et
un ensemble capteur d'image (12) est agencé à l'intérieur du premier espace d'assemblage (114), la région de connexion externe (113) étant agencée au moins de manière à recouvrir une unité photosensible de l'ensemble capteur d'image (12),
dans lequel l'ensemble capteur d'image (12) est **caractérisé en ce qu'**il comprend un filtre optique (123), un corps de capteur (122) et une carte de circuit imprimé (124), le filtre optique (123) est agencé au-dessus du corps de capteur (122) et recouvre l'unité photosensible (121) du corps de capteur (122), et la carte de circuit imprimé (124) est agencée au-dessous du corps de capteur (122),
dans lequel l'ensemble capteur d'image comprend en outre un couvercle de protection (125) et un élément d'étanchéité (126), le couvercle de protection (125) recouvre des régions de bord de l'ensemble capteur d'image (12), la partie perméable à la lumière (111) comprend une plaque de recouvrement perméable à la lumière (1112), l'élément d'étanchéité (126) étant agencé au niveau d'une région de bord entre la plaque de recouvrement perméable à la lumière (1112) et le couvercle de protection (125), et étant en ajustement étanche respectivement avec la plaque de recouvrement perméable à la lumière (1112) et avec le couvercle de protection (125).

2. Terminal mobile selon la revendication 1, dans lequel le boîtier de dispositif (11) comprend un premier support (115) comprenant un corps de support (1151) et un premier espace de logement (1152) entouré par le corps de support (1151), et l'ensemble capteur d'image (12) est assemblé dans le premier espace de logement (1152).

3. Terminal mobile selon la revendication 2, dans lequel le corps de support (1151) comprend une structure de dissipation thermique (1153), et au moins une partie de l'ensemble capteur d'image (12) est en contact ajusté avec la structure de dissipation thermique (1153).

4. Terminal mobile selon les revendications 2 ou 3, dans lequel le terminal mobile (1) comprend en outre un couvercle d'antenne (117) formé d'un seul tenant avec le premier support (115).

5. Terminal mobile selon l'une quelconque des revendications 1 à 4, dans lequel le boîtier de dispositif (11) comprend un cadre intermédiaire (116) et une plaque de recouvrement décorative (14) assemblée dans le cadre intermédiaire (116), et la partie de connexion externe (112) est agencée sur la plaque de recouvrement décorative (14).

6. Terminal mobile selon la revendication 5, dans lequel l'ensemble capteur d'image (12) est assemblé et fixé avec la plaque de recouvrement décorative (14), facultativement, la plaque de recouvrement décorative (14) comprend un corps de plaque de recouvrement (141) et une structure d'installation (142), le corps de plaque de recouvrement (141) étant agencé à une périphérie de la partie perméable à la lumière (111) et recouvrant au moins une partie du terminal mobile (1), et la structure d'installation (142) entourant et formant un deuxième espace de logement (1421) à l'intérieur du terminal mobile (1), l'ensemble capteur d'image (12) étant assemblé dans le deuxième espace de logement (1421).

7. Terminal mobile selon la revendication 5, dans lequel le terminal mobile (1) comprend en outre une pluralité d'éléments de connexion filetés (1161), la plaque de recouvrement décorative (14) et le cadre intermédiaire (116) étant fixés par les éléments de connexion filetés (1161).

8. Terminal mobile selon l'une quelconque des revendications 1 à 7, dans lequel la dimension de l'unité photosensible (121) de l'ensemble capteur d'image (12) est supérieure ou égale à 16 mm.

9. Terminal mobile selon l'une quelconque des revendications 1 à 8, dans lequel la partie de connexion externe (112) comprend au moins une structure parmi une structure de serrage, une structure de connexion filetée et une structure de connexion magnétique, agencée dans le boîtier de dispositif (11).

10. Terminal mobile selon l'une quelconque des revendications 1 à 9, dans lequel le terminal mobile (1) comprend en outre un corps de recouvrement décoratif assemblé à l'extérieur du boîtier de dispositif (11) et recouvrant au moins une partie parmi la partie perméable à la lumière (111) et la partie de connexion externe (112).

11. Terminal mobile selon l'une quelconque des revendications 1 à 10, dans lequel le terminal mobile (1) comprend en outre au moins un module parmi un module de caméra principale (13) et un module de caméra ultra grand-angle (15), et le boîtier de dispositif (11) est pourvu d'un deuxième espace d'assemblage (118), au moins un module parmi le module de caméra principale (13) et le module de caméra ultra grand-angle (15) étant assemblé à demeure dans le deuxième espace d'assemblage (118).

12. Terminal mobile selon la revendication 11, dans lequel, dans une direction d'épaisseur du terminal mobile (1), une zone en hauteur de l'ensemble capteur d'image (12) est différente d'une hauteur d'au moins un module parmi le module de caméra principale (13) et le module de caméra ultra grand-angle (15),
et/ou, dans une direction perpendiculaire à la direction d'épaisseur du terminal mobile (1), le module de caméra principale (13) et le module de caméra ultra grand-angle (15) sont agencés sur deux côtés de l'ensemble capteur d'image (12),
et/ou, la partie perméable à la lumière (111) recouvre le deuxième espace d'assemblage (118), et le premier espace d'assemblage (114) est en communication avec le deuxième espace d'assemblage (118).

13. Dispositif mobile, comprenant: un ensemble objectif externe (2) et le terminal mobile (1) selon l'une quelconque des revendications 1 à 12, l'ensemble objectif externe (2) est assemblé de manière amovible avec une partie de connexion externe (112), positionné et installé sur une région de connexion externe (113) du terminal mobile (1).

14. Dispositif mobile selon la revendication 13, dans lequel l'ensemble objectif externe (2) comprend un objectif externe (22) et un adaptateur (21), l'adaptateur (21) est connecté de manière amovible respectivement à l'objectif externe (22) et au terminal mobile (1), et l'adaptateur (21) comprend une première extrémité de connexion de positionnement (211) positionnée et connectée à la partie de connexion externe (112) et une deuxième extrémité de connexion de positionnement (212) positionnée et connectée à l'objectif externe (22), la première extrémité de connexion de positionnement et la deuxième extrémité de connexion de positionnement (212) sont en communication l'une avec l'autre, et une distance de la surface de l'unité photosensible (121) de l'ensemble capteur d'image (12) à un plan d'accès de l'objectif externe (22) est égale au tirage mécanique de l'objectif externe (22),
et/ou, l'adaptateur (21) comprend un premier contact conducteur (215) et un deuxième contact conducteur (213), le premier contact conducteur (215) étant connecté électriquement à une carte principale du terminal mobile (1), et le deuxième contact conducteur (213) étant connecté électriquement à l'objectif externe (22),
et/ou, l'adaptateur (21) comprend une ouverture perméable à la lumière (214) adaptée à la partie perméable à la lumière (111), l'ouverture perméable à la lumière (214) s'adaptant à l'unité photosensible de l'ensemble capteur d'image (12) en termes de forme structurelle et de dimensions.
